# EUROPEAN PATENT SPECIFICATION

(11) **EP 2 427 586 B1**
(45) Date of publication and mention of the grant of the patent: **25.11.2020**
(21) Application number: 10727350.0
(22) Date of filing: 05.05.2010
(51) Int. Cl.: H05H 1/24, C23C 14/34, C23C 14/00, C23C 14/35, H01J 37/34

(54) **METHOD FOR THE PRODUCTION OF OXIDE AND NITRIDE COATINGS AND ITS USE**
VERFAHREN ZUR HERSTELLUNG VON OXID- UND NITRIDÜBERZÜGEN UND VERWENDUNG DAVON
PROCÉDÉ DE PRODUCTION DE REVÊTEMENTS D'OXYDES ET DE NITRURES ET SON UTILISATION

(30) Priority: 07.05.2009 DE 102009020162; 07.05.2009 US 213106 P
(43) Date of publication of application: 14.03.2012
(73) Proprietor: Fraunhofer-Gesellschaft zur Förderung der angewandten Forschung e.V., 80686 München (DE)
(72) Inventor: BRUNS, Stefan, 38104 Braunschweig (DE); WERNER, Oliver, 38118 Braunschweig (DE); VERGÖHL, Michael, 38162 Destedt (DE)
(74) Representative: Pfenning, Meinig & Partner mbB
(86) International application number: PCT/EP2010/002756
(87) International publication number: WO 2010/127845

(56) References cited:
- EP-A2- 0 347 567
- WO-A1-2006/049566
- DE-A1- 19 919 742
- US-B1- 6 274 014
- KONSTANTINIDIS S ET AL: "Titanium oxide thin films deposited by high-power impulse magnetron sputtering" THIN SOLID FILMS, ELSEVIER-SEQUOIA S.A. LAUSANNE, CH LNKD- DOI:10.1016/J.TSF.2006.07.089, vol. 515, no. 3, 23 November 2006 (2006-11-23), pages 1182-1186, XP025006001 ISSN: 0040-6090 [retrieved on 2006-11-23]
- Michael Vergöhl ET AL: "New developments in magnetron sputter processes for precision optics", Optical Sensing II, vol. 7101, 16 September 2008 (2008-09-16), page 71010B, XP055332606, 1000 20th St. Bellingham WA 98225-6705 USA ISSN: 0277-786X, DOI: 10.1117/12.797190 ISBN: 978-1-62841-971-9
- NOBORU SHIBATA: "PLASMA-CHEMICAL VAPOR-DEPOSITED SILICON OXIDE/SILICON OXYNITRIDE DOUBLE-LAYER ANTIREFLECTIVE COATING FOR SOLAR CELLS", JAPANESE JOURNAL OF APPLIED PHYSICS, JAPAN SOCIETY OF APPLIED PHYSICS, JP, vol. 30, no. 5, 1 May 1991 (1991-05-01), pages 997-1001, XP000263711, ISSN: 0021-4922, DOI: 10.1143/JJAP.30.997
- LAU K ET AL: "Reactive pulse magnetron sputtered SiO"xN"y coatings on polymers", THIN SOLID FILMS, ELSEVIER-SEQUOIA S.A. LAUSANNE, CH, vol. 517, no. 10, 31 March 2009 (2009-03-31), pages 3110-3114, XP026005688, ISSN: 0040-6090, DOI: 10.1016/J.TSF.2008.11.084 [retrieved on 2008-11-20]

## Description

The present invention relates to a method for the enhanced production of insulating layers by High Power Impulse Magnetron Sputtering (HiPIMS) or High Power Pulsed Magnetron Sputtering (HPPMS). This method is preferably used for the production of oxynitride layers with variable amounts of oxide and nitride, preferably based on silicon and aluminium.

In the manufacture of insulating oxide or nitride films by sputtering are often used metallic targets. In a reactive process, the reactive gas, e.g. O₂ or N₂, is discharged into the process chamber where the metal, e.g. Ti, Al, Nb, Ta, Zr, Hf, Bi, Cr, Zn or Sn, or a semi-conductor material like Si is sputtered from a target. The advantages of metallic targets are generally lower production costs as well as the realisation of higher deposition rates. Hence, for the deposition of Al₂O₃ layers, high-purity aluminium targets, or, in the case of SiO₂ layers, high-purity silicone targets are used. Since the oxide of these materials, i.e. dielectrics, are highly electrically insulating, direct current sputtering is not suitable due to the charging of the targets and the formation of arc discharges. Thus, in these processes, the oxygen partial pressure is controlled so that the pressure is low enough to keep the sputtering target free from oxidic depositions and, on the other hand, is high enough to allow the formation of stoichiometric layers.

Another option to minimize arcing is based on the spatial separation of reactive gas and the sputtering cathode.

US 4,851,095 teaches a metallic sputtering process in the cylindrical or rotational arrangement, wherein after deposition of a very thin metallic layer, the metal is oxidized in a microwave plasma or an RF plasma. The substrate to be coated has to be moved quickly between the material source and the plasma source, because only a relatively thin metal layer can be fully oxidized. Another option is to deposit sub-stoichiometric layers, which are subsequently oxidized with a plasma source. In this case, the metallic layers are deposited by DC or by common pulsed sputter techniques.

Another option for a stable process free of arcing is based on pulsed excitations by medium frequency, i.e. 10 to 350 kHz, which allows the discharge of the electric charges. In this process, a single or a double cathode can be used. For HiPIMS processes in contrast to normally pulsed processes, only low frequencies, i.e. under 1.000 Hz, can be used. To solve this problem, WO 2008/106956 A3 teaches a device which allows to superimpose DC with HiPIMS pulses with a lower frequency. However, this is not sufficient for insulating materials. Medium frequency pulses provide a stable plasma, while the HiPIMS pulses provide the modified layer properties. It has been found in HiPIMS processes that the sputter erosion track, i.e. the area from which the target material is dissolved by plasma bombardment, is broader than for common pulsed sputtering processes. As a reason, a slow-down of a magnetic field of the magnetron by the high plasma density was adopted. In consequence, the superimposition of different pulses is incomplete. The stabilization of a discharge by the MF discharge only takes place in the sputtering areas. Since in HiPIMS processes, a broader area is sputtered, arcing also occurs outside of the sputter erosion track.
In Michael Vergöhl et al. ("New developments in magnetron sputter processes for precision optics", Optical Sensing II , vol. 7101, 16 September 2008, p. 71010B) an ionized magnetron sputtering technique is proposed for improving the production of precision optical coatings. A higher homogeneity of the disposed layer is achieved here by rotating the substrate which is to be coated. However, the publication does not suggest a strategy for minimizing the oxidation of the metallic sputter target in order to further reduce undesirable arcing.

Another aspect of the present disclosure relates to the material aspects of oxynitride layers. SiOₓN_{y} layers can be used as optical functional layers, e.g. as scratch-resistant layers in optical applications, transparent diffusion barrier layers, anti-reflection coatings or covering layers in flat glass or solar cell systems.

Pure silicon nitride (Si₃N₄) layers are characterized by a high hardness (up to 30 GPa) and a high layer compressive stress. Stoichiometric, dense Si₃N₄ layers have a relatively high refractive index of 2,05. Porous or sub-stoichiometric SiNₓ layers have a lower refractive index and in some cases have absorbing properties. SiO₂ films are typical materials with a low refractive index of 1,46 used in optical applications.

SiOₓN_{y} layers and Si₃N₄ layers are used in optical applications, e.g. for anti-reflection coatings or, for a higher refractive index (n = 2,05 for 550 nm), as high refractive layers in optical filters. By precise adjustment of the nitrogen content, the refractive index can be set between 1,45 and 2,05 so that filters with a continuously varying refractive index can be prepared (gradient layers, Rugate filters).

SiOₓN_{y} layers can be prepared in a reactive process by using a semi-conducting target (silicon) and adding nitrogen and oxygen. In the production of SiOₓN_{y} layers in reactive sputtering processes, the problem is that due to its inactivity in the process, nitrogen is incorporated in the layer very slowly. For optical applications is an amorphous layer structure preferred.

For the deposition of high refractive Si₃N₄ layers, pulsed sputtering processes have to be used since common DC sputtering processes cannot provide high refractive Si₃N₄ layers. In M. Vergöhl et al. "Real-time control of reactive magnetron-sputter deposited optical filters by in-situ spectroscopic ellipsometry", Thin Solid Films, Vol. 377/378 (2000), S. 43-47, the deposition of Si₃N₄ layers by medium frequency sputtering techniques are described. Also this process is characterized by its inactivity. The deposition process from the fully oxidized target to a fully metallic target takes a few minutes. To get a 50 % mixture of nitride and oxide, it is necessary to introduce much more nitrogen into the process chamber than oxygen. The reactivity of oxygen is much higher and thus is incorporated in the layer in a higher amount (N₂:O₂ is 20:1). Moreover, Si₃N₄ layers often are absorbing for short wavelengths due to the minor incorporation of the nitrogen into the layer.

Lau et al., "Reactive pulse magnetron sputtered SiOxNy coatings on polymers", Thin Solid Films 517 (10), (2009), S. 3110-3114, used a pulsed sputter technique for the deposition of SiOₓN_{y} layers based on a medium frequency technique using double ring magnetrons.

It was therefore an object of the present invention to overcome the disadvantages of the prior art and to provide stoichiometric layers with improved mechanical and optical properties. It is a further object of the present invention to provide a method for producing such coatings which is easy to handle and offers improved deposition rates.

This technical problem is solved by the method for producing compound coatings with the features of claim 1. Claim 6 mentions different uses for the inventive method. The further dependent claims describe preferred embodiments.

According to the present invention, a method for depositing oxide, nitride or oxynitride layers is provided which is based on a reactive pulse magnetron sputtering with a High Power Impulse Magnetron Sputtering (HiPIMS) which is superimposed by medium frequency (MF) pulses of 10 kHz to 350 kHz or radio frequency (RF) pulses with 13,56 or 27,12 MHz or even micro wave with several GHz in which a cylindrical rotating cathode (1,2) is used and wherein the cathode (1,2) is at least partially excited by High Power Impulse Magnetron Sputtering pulses. The layers preferably comprise a metal selected from the group consisting of Al, B, Cr, Ti, Sc,Zn, Y, Zr, Nb, Hf, Ta and Mg, or a semi-conductor like Si.

It was found that the inventive reactive HiPIMS process can provide much better stoichiometric compound layers, in particular layers of Si₃O₄, Si₃N₄ and SiOₓN_{y}, from a semi-conductive silicium target.

In particular, the following key benefits have been found:
- The transparency in the short-wave spectrum range below 400 nm has been improved.
- The inventive layers with the same amount of nitrogen show less strain.
- It is possible to increase the amount of nitrogen within the inventive layers, though the same ratio between oxygen and nitrogen is used.
- In comparison to the methods of the prior art, which provide crystalline layers, the method of the present invention allows the deposition of amorphous layers.

Moreover, the present invention allows the separation of neutral gas and reactive gas which allows operating the HiPIMS discharge in a pure neutral gas atmosphere.

In some HiPIMS processes the location of the oxidation/nitridation and the location of deposition are separated spatially. Thus, the HiPIMS process can take place at the location of the metallic layer formation having the advantage that the formation of isolating layers on the target can be avoided and the arcing is reduced. In one aspect of the current invention the target can be chosen from a metallic material so that the formation of negatively charged reactive gas atoms, like oxygen ions, can be avoided. Such ionized reactive gas atoms would be accelerated by the negatively charged target towards the substrate which often leads to layer defects.

For depositing the thin metallic or semi-conductive layers in the HiPIMS process, a rotary disk or rotary drum can be used for periodically moving the substrates between magnetron and plasma source.

According to a second aspect, it is possible to spatially separate the oxygen inlet from the sputtering source. However, this separation is not mandatory. An operation without arcing can be realized by superimposing pulses of HiPIMS and medium frequency. By using rotatables, the erosion zone is moving over the target surface (magnetron is fixed and material tube is rotating). Hence, a re-deposition with oxidic materials on the target can be avoided since these deposits are sputtered off by any rotation.

The present invention will now be described in detail with reference to the following figures and examples, which by no means shall limit the scope of the invention.

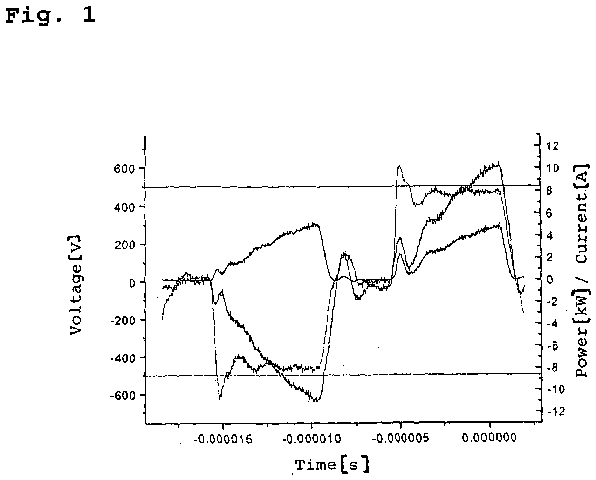

Fig. 1 shows a plot according to the setup of example 1.

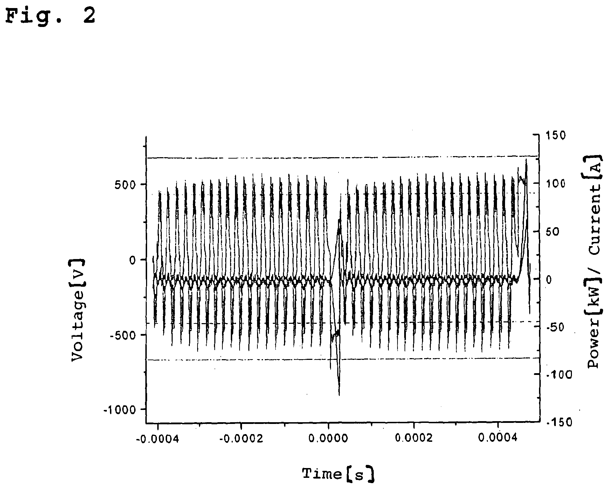

Fig. 2 shows a plot according to the setup according to example 2.
Fig. 3 shows an embodiment of a HIPMS arrangement.
Fig. 4 shows a first embodiment of the present invention.
Fig. 5 shows a second embodiment of the present invention.

### Example 1 (non inventive)

### SiOₓN_{y} coatings

For this example, a box-coater with linear planar targets within a double magnetron arrangement was used. Two different pulse units were connected to the cathodes: The first is designed for mid-frequency up to 50 kHz and maximum peak-current of 200 A (Melec SPIK 1000), while the second has a maximum frequency of only 4 kHz but maximum peak-current of 1000 A (Melec SPIK 2000).
The pulse units are capable for unipolar (one target is fixed cathode and other one is anode) as well as for bipolar (cathode and anode are switched permanently) pulse patterns. Within this example the bipolar mode was selected.

To define the pulse pattern for times, T_{on,1}, T_{off,1}, T_{on,2}, T_{off,2} are necessary (for each pulse unit in case of superimposed process HIPIMS + mid-frequency). For Tₒₙ-times voltage is applied to target 1 respectively target 2 whereas for T_{off}-times supply is switched off by the pulse unit. Minimum pulse times are 5 µs for SPIK 1000 and 20 µs for SPIK 2000 with a minimum period of 20 µs respectively 250 µs.
The pulse pattern is set by an IFU Diagnostic Systems Pulse Pattern Controller (PPC) and over coaxial cable fed into the pulse unit. Conditions are +5 V and -5V for the two on-times and 0 V for off-times.

Two different processes were carried out to compare sole mid-frequency (MF) with superimposed HIPIMS and mid-frequency (HIPIMS+MF). In the mid-frequency (MF) process following parameters were set:
- Silicon targets (Leybold PK 500)
- Pulse unit: Melec Spik 1000
- Bipolar pulse pattern
- Pulse pattern: 5 µs on-time, 5 µs off-time, frequency of 50 kHz
- Base pressure: 4,8E-6 mbar
- Gas flows: 120 sccm Ar, 15 sccm O₂, 75 sccm N₂
- uncontrolled process (compound mode)
- Oxygen partial pressure: p_{O2} = 1,5E-4 mbar
- Process pressure: 4,0 E-3 mbar
- Average power at loading DC supply: 2400 W, 508 V, 4,75 A
- Average power at target: 1,914 kW (486 W loss within pulsing unit and cables)

The maximum peak current was 11 A.

The second process with superimposed HIPIMS+MF was operated with following parameters:
- Silicon targets (Leybold PK500)
- Pulse unit: Melec Spik 2000
- Bipolar pulse pattern
- Pulse pattern: 20 µs HIPIMS pulse, 10 µs pause, 20 cycles MF with 5 µs on-time and 5 µs off-time
- Base pressure: 4,8E-6 mbar
- Gas flows: 120 sccm Ar, 15 sccm O₂, 75 sccm N₂
- uncontrolled process (compound mode)
- Oxygen partial pressure: p_{O2} = 1,5 E-4 mbar
- Process pressure: 4,0E-3 mbar
- Average power at loading DC supply for HIPIMS pulse unit: 2350 W, 669 V, 3,1 A
- Average power at loading DC supply for MF pulse unit: 500 W, 428 V, 1,19 A
- Average power at target: 2,209 kW (641 W loss within pulsing unit and cables)

The maximum peak current was 126 A.

Pieces of silicon wafers were coated in each case for 10 minutes and characterized by spectral ellipsometry. The following model was used to fit theory with measurements (shown in table 1).

**Table 1**

| | | | |
|---|---|---|---|
| | Air | NK Layer | n=1.0000 |
| 0,00 nm | Si3N4 (Palik) | File Layer | n=2.0312 |
| **274,64 nm** | **Interface: Si3N4 (Palik)/SiO2 (Palik)** | **EMA 2 layer** | **n=1.4730** |
| 0,00 nm | SiO2 (Palik) | File Layer | n=1.4599 |
| | | | n=4.0741 |
| | Silicon (100) (Jellison) | File Layer | k=0.0288 |

Results for mixture calculated by Bruggemann-model are shown in table 2.

**Table 2**

| | **thickness (nm)** | **refractive index (@550 nm)** | **Si₃N₄ - fraction** |
|---|---|---|---|
| **MF** | 274,64 | 1,47 | 2,5 % |
| **HIPIMS+MF** | 261,65 | 1,52 | 11,8 % |

Only with superimposed process, the HIPIMS plasma with ionised target material was stable enough for the deposition of SiOₓN_{y} layers.

Coatings from the process with highly ionised HIPIMS-plasma showed a considerable bigger fraction of Si₃N₄ than those from pure MF-process with similar average power. The peak current of the HIPIMS+MF is a factor of eleven higher in respect to that of MF which leads to the higher ionisation.

To realise stable plasma conditions, the superposition of the HIPIMS with a MF process is necessary and enables the deposition of highly electrical insulating materials (like SiOxNy or AlOₓN_{y}). Without the MF through the off-times of HIPIMS, the process runs into arcing whereby the coating or at least the properties of itself are destroyed.

The second example shows another way to prevent this problem.

### Example 2 (non inventive)

### HIPIMS arrangement for reduced arcing

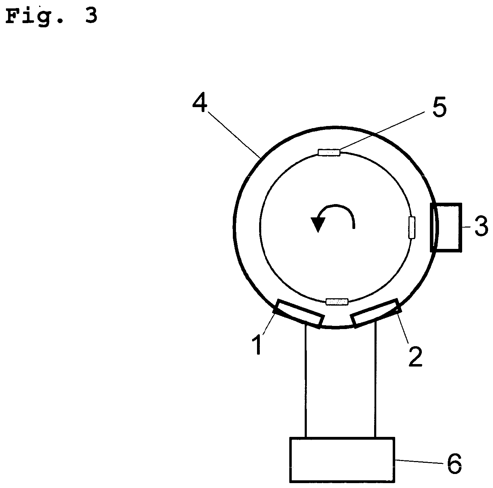

Fig. 3 shows an arrangement for the deposition of oxide or nitride coatings with reduced arcing. In doing so, the reactive gas, preferred oxygen, is kept away from the target and the influence of negatively charged oxygen ions is reduced. The substrates 5 moving through the vacuum chamber 4 on a rotating drum. The magnetrons 1 and 2 are supplied by a HIPIMS-pulse unit 6 with bipolar or unipolar high energy pulses. The magnetrons are preferably equipped with metal targets (Al, Ti, Hf, Zr, Ta, Nb, etc.) or with silicon. At the magnetrons, neutral argon is led in. In this part of the chamber, the deposited layer thickness ranges from few angstroms to few nanometers. Alternatively, a process with only one magnetron is possible. At the plasma source 3, which may be driven by radiofrequency or microwave, the thin films are oxidized to obtain transparent coatings.

The arrangement shown in this figure may also be used for a rotating disk instead of rotating drum chamber.

### Example 3

### HIPIMS arrangement for reduced arcing with rotatable cathodes

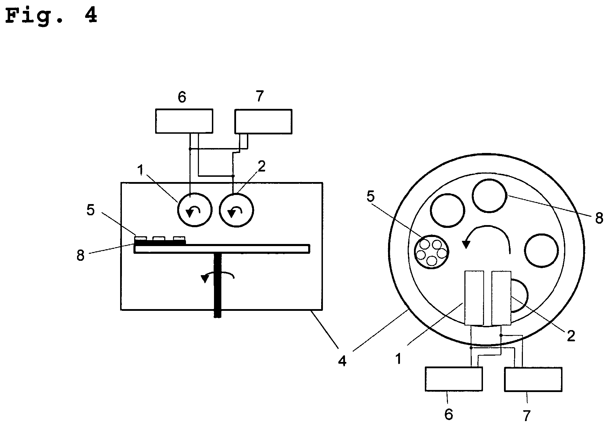

Fig. 4 shows an arrangement for a superimposed HIPIMS+MF process under utilization of rotatable cathodes (rotatables), 1 and 2. Optionally the process can be driven with one single cathode.

The cathodes are supplied with HIPIMS pulses from a HIPIMS pulse unit 6 as well as superimposed MF pulses from a MF pulse unit 7. The superimposition may also be direct current or radiofrequency instead of mid-frequency. HIPIMS as well as MF pulses may be unipolar or bibolar. For the pulse creation, an arrangement like shown in DE 10 2007 011 230 A1 may be used.

Here, the mixed feeding of neutral (preferably argon) and reactive gas (preferably oxygen) can also be carried out at the place of the magnetron because the rotation of the cathode ensures constant target surface for all times (only very thin oxide layer). By partial pressure control (for example with lambda probe or optical plasma emission monitoring), the bombardment of the layer by negatively charged oxygen ions can be minimized. Closed loop control with pulse frequency is described in DE 10 2006 061 324 B4 (Sittinger et al.).

In the shown arrangement, the substrates 5 are coated in a rotating disk chamber. The substrates are on a disk 8 which is placed on a rotating system so that they are passing periodically under the magnetron. An arrangement with rotating drum is also possible. Large substrates may be coated in an inline-geometry.

### Example 4

### HIPIMS arrangement for reduced arcing with rotating cathodes and separate plasma source

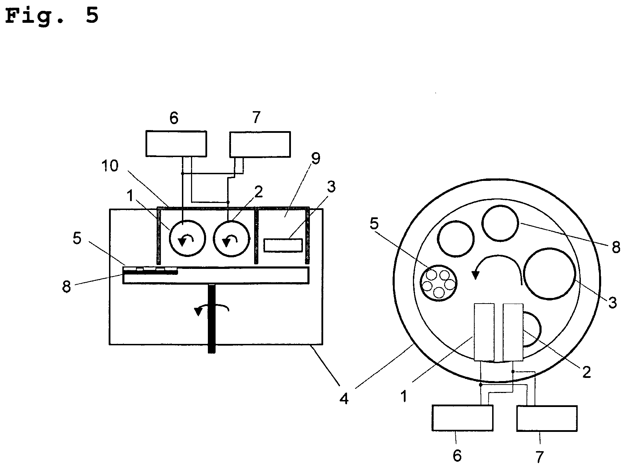

Fig. 5 shows an arrangement for a superimposed HIPIMS+MF process under utilization of rotatable cathodes (rotatables), 1 and 2. Optionally, the process can be driven with one single cathode.

The cathodes are supplied with HIPIMS pulses from a HIPIMS pulse unit 6 as well as superimposed MF pulses from a MF pulse unit 7. The superimposition may also be direct current or radio frequency instead of mid-frequency. HIPIMS as well as MF pulses may be unipolar or bibolar.

Additionally to example 3, a plasma source 3 is applied. Reactive gas (oxygen, nitrogen or sulphur, fluorine or selenium) is led through so that in the plasma in front of the plasma source, the layers are subsequently treated to improve the stoichiometry.

The movement of the substrates is rotatory with relatively high speed (typically from 10 to circa 200 rpm) so that only thin metal or semiconducting layers with less than 1 nm (preferably less than 0,2 nm) are deposited which may be effectively oxidized (or nitrided) by the plasma source.

At the magnetron, a mixture of neutral and reactive gas may be used wherein the reactive gas partial pressure is reduced. In both cases, the full oxidation at the target and therewith the creation of negatively charged reactive gas ions is prevented. The negatively charged ions could otherwise be accelerated by the high negative potential of the target in the direction of the substrate.

Purposeful is a separation between the coating and after-treatment for example by the use of different part chambers with high gas separation. In this example, it is realised by blinds between coating station 10 and plasma after-treatment station 9.

## Claims

1. Method for depositing oxide, nitride or oxynitride coatings by a reactive pulse magnetron sputtering with a High Power Impulse Magnetron Sputtering which is superimposed by medium frequency pulses of 10 kHz to 350 kHz or radio frequency pulses of 13,56 or 27,12 MHz or even micro wave with several GHz
**characterised in that**
a cylindrical rotating cathode (1,2) is used wherein the cathode (1,2) is at least partially excited by High Power Impulse Magnetron Sputtering pulses.

2. Method of claim 1, **characterised in that** the oxide, nitride or oxynitride coatings comprise a metal, preferably selected from the group consisting of Si, Al, B, Cr, Ti, Sc, Zn, Y, Zr, Nb, Hf, Ta and Mg, or a semiconductor, preferably Si.

3. Method of any of the preceding claims, **characterised in that** the reactive gas is selected from the group consisting of oxygen, nitrogen, sulfur, fluor, selenium.

4. Method of any of the preceding claims, **characterised in that** the partial pressure of the reactive gas is predetermined to avoid or significantly reduce a layer deposition at the target.

5. Method of any of the preceding claims, **characterized by** producing a coating of Si₃N₄ or Si₃₋₂ₓO₂ₓN₄₍₁₋ₓ₎, wherein x = 0 ... 1.

6. Use of the method of any of the claims 1 to 5 for producing anti-reflection coating, optical filters.

## Patentansprüche

1. Verfahren zum Abscheiden von Oxid-, Nitrid- oder Oxynitridbeschichtungen durch ein reaktives Pulsmagnetronsputtern mit einem Hochleistungsimpulsmagnetronsputtern, das durch Mittelfrequenzimpulse von 10 kHz bis 350 kHz oder Radiofrequenzimpulse von 13,56 oder 27,12 MHz oder sogar Mikrowellen mit mehreren GHz überlagert wird **dadurch gekennzeichnet, dass** eine zylindrische rotierende Kathode (1,2) verwendet wird, wobei die Kathode (1,2) zumindest teilweise durch Hochleistungsimpulsmagnetronsputterpulse angeregt wird.

2. Verfahren nach Anspruch 1, **dadurch gekennzeichnet, dass** die Oxid-, Nitrid- oder Oxynitridbeschichtungen ein Metall, vorzugsweise ausgewählt aus der Gruppe bestehend aus Si, AI, B, Cr, Ti, Sc, Zn, Y, Zr, Nb, Hf, Ta und Mg, oder einen Halbleiter, vorzugsweise Si, enthalten.

3. Verfahren nach einem der vorangehenden Ansprüche, **dadurch gekennzeichnet, dass** das reaktive Gas ausgewählt ist aus der Gruppe bestehend aus Sauerstoff, Stickstoff, Schwefel, Fluor, Selen.

4. Verfahren nach einem der vorangehenden Ansprüche, **dadurch gekennzeichnet, dass** der Partialdruck des reaktiven Gases vorbestimmt wird, um eine Schichtabscheidung am Target zu vermeiden oder erheblich zu verringern.

5. Verfahren nach einem der vorangehenden Ansprüche, **gekennzeichnet durch** Herstellen einer Beschichtung aus Si₃N₄ oder Si₃₋₂ₓO₂ₓN₄₍₁₋ₓ₎, wobei x = 0 ... 1.

6. Verwendung des Verfahrens nach einem der Ansprüche 1 bis 5 zum Herstellen von Antireflexbeschichtungen, optischen Filtern.

## Revendications

1. Méthode pour déposer des revêtements d'oxyde, de nitrure ou d'oxynitrure par une pulvérisation à magnétron par impulsions réactives au moyen d'une pulvérisation à magnétron par impulsions à haute puissance qui est superposée par des impulsions à moyenne fréquence de 10 kHz à 350 kHz ou des impulsions à radiofréquence de 13,56 ou 27,12 MHz ou même des micro-ondes avec plusieurs GHz,
**caractérisée en ce qu'**une cathode rotative cylindrique (1, 2) est utilisée, dans laquelle la cathode (1, 2) est au moins partiellement excitée par des impulsions de pulvérisation à magnétron par impulsions à haute puissance.

2. Méthode selon la revendication 1, **caractérisée en ce que** les revêtements d'oxyde, de nitrure ou d'oxynitrure comprennent un métal, de préférence choisi dans le groupe constitué par Si, Al, B, Cr, Ti, Sc, ZN, Y, Zr, Nb, Hf, Ta et Mg, ou un semiconducteur, de préférence Si.

3. Méthode selon l'une quelconque des revendications précédentes, **caractérisée en ce que** le gaz réactif est choisi dans le groupe constitué par l'oxygène, l'azote, le soufre, le fluor, le sélénium.

4. Méthode selon l'une quelconque des revendications précédentes, **caractérisée en ce que** la pression partielle du gaz réactif est prédéterminée pour qu'une déposition de couche au niveau de la cible soit évitée ou significativement réduite.

5. Méthode selon l'une quelconque des revendications précédentes, **caractérisée par** la production d'un revêtement de Si₃N₄ ou de Si₃₋₂ₓO₂ₓN₄₍₁₋ₓ₎, où x = 0 à 1.

6. Utilisation de la méthode selon l'une quelconque des revendications 1 à 5 pour produire des filtres optiques à revêtement antireflet.
